# EUROPEAN PATENT APPLICATION

(11) **EP 0 769 811 A1**
(43) Date of publication of application: **23.04.1997**
(21) Application number: 95830443.8
(22) Date of filing: 19.10.1995
(51) Int. Cl.: H01L 21/336, H01L 21/332, H01L 21/331, H01L 29/10

(54) **Method of fabricating self aligned DMOS devices**

(71) Applicant: CONSORZIO PER LA RICERCA SULLA MICROELETTRONICA NEL MEZZOGIORNO, 95121 Catania (IT)
(72) Inventor: Ronsisvalle, Cesare, I-95126 Catania (IT)
(74) Representative: Cerbaro, Elena

(57) **Abstract**

The power MOS switching device (1) presents an enriched contact region (35) with an electrode (K) between and self-aligned with the P-short regions (7); and the fabrication process includes the steps of: forming cells (10) in a wafer (100) of semiconductor material; depositing a nitride layer (40) on the surface (18) of the wafer (100); forming a source mask (30); shaping the nitride layer using the source mask; implanting the P-short regions (7); growing a thermal oxide layer (39) on the P-short regions, to the side of the remaining nitride portions (40); removing the nitride portions; and implanting the enriched region (35) as masked by the thermal oxide layer.

## Description

The present invention relates to a method of fabricating a power MOS switching device, and to a power MOS switching device fabricated thereby.

As is known, for some years now, the power device family has included a new component known as a MOS controlled thyristor or MCT, which is described in detail, for example, in the article entitled "Search for the Perfect Switch" by V.A.K. Temple, PCI, June 1988 Proceedings. An MCT is a thyristor that can be turned on and off by an insulated gate region, integrates a turn-on and a turn-off MOSFET of opposite channel types, and presents the same structure as an IGBT (insulated-gate bipolar transistor) but with an extra layer constituting a base region. As compared with traditional power components such as an IGBT, an MCT presents a greater conducting area for a given cell size and hence a higher current-carrying capacity by not forcing the current to flow through a surface channel which typically accounts for most of the dynamic resistance of the component.

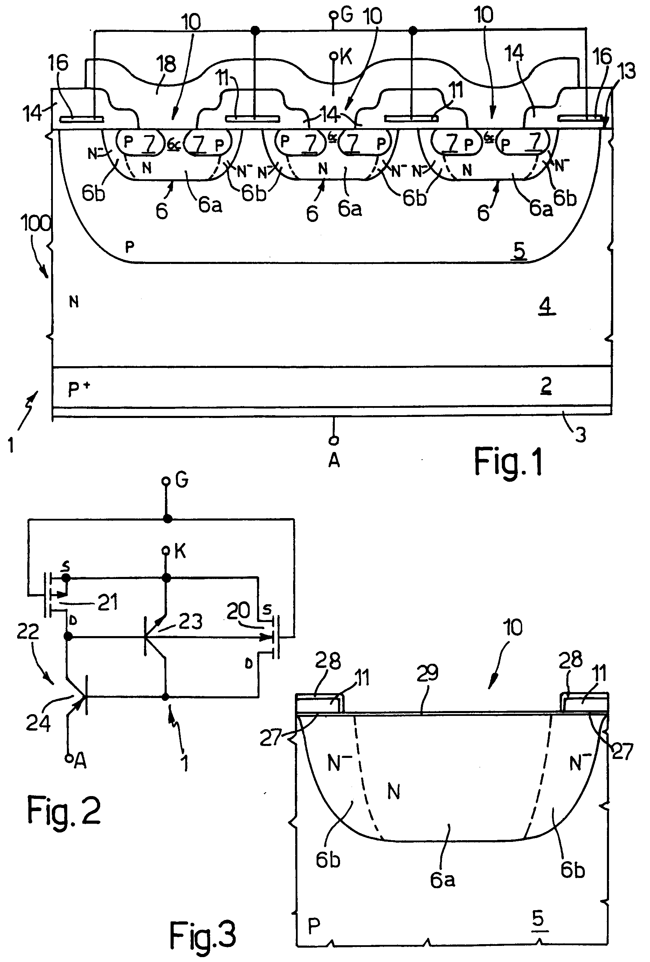

One embodiment of an MCT is shown by way of example in Figure 1.

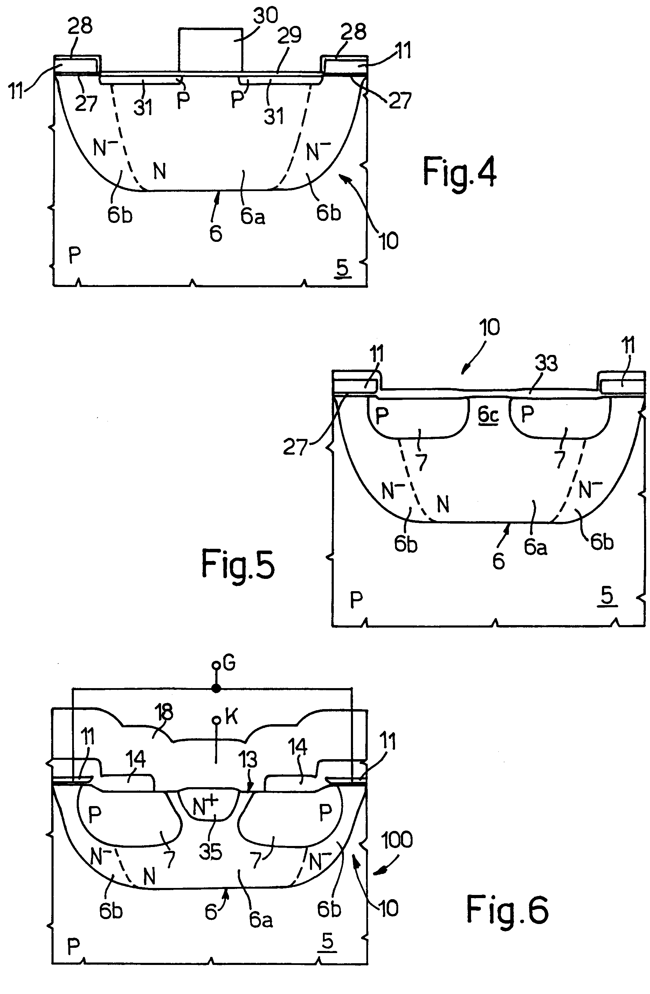

The Figure 1 MCT, indicated as a whole by 1, is formed in a wafer 100 of semiconductor material (monocrystalline silicon) comprising a P+ type substrate 2 connected to a terminal A by a metal region 3; an N type epitaxial layer 4 over substrate 2; a P type base well 5 diffused inside epitaxial layer 4; a number of N wells 6 diffused inside base well 5; and pairs of P type P-short regions 7 formed in each emitter region 6. Each N well 6 comprises a heavily doped inner portion (indicated N in Figure 1) forming an emitter region 6a, and a lightly doped outer portion 6b (indicated N⁻) externally surrounding P-short regions 7. In Figure 1, 6c indicates a portion of emitter region 6a located between P-short regions 7.

N wells 6 and P-short regions 7 embedded in them form MOS cells 10; polysilicon gate regions 11 over surface 13 of wafer 100 overlap adjacent cells 10, and are embedded in known manner in oxide regions 14 insulating them electrically from surface 13; and further gate regions 16 overlap the outer portions 6b of the outermost cells 10 (to the right and left in Figure 1) and the portion of epitaxial layer 4 laterally defining base well 5, and are also embedded in insulating oxide regions 14.

Gate regions 11 and 16 are all connected electrically to one another and to a terminal G; and a metal region 18 connected to a terminal K connects portions 6c of cells 10.

The Figure 1 structure may be represented electrically as illustrated in Figure 2, which shows an N-channel MOS turn-on transistor 20; a P-channel MOS turn-off transistor 21; and a thyristor 22 represented by an NPN bipolar transistor 23 and a PNP bipolar transistor 24. More specifically, the drain terminal D of turn-off transistor 21 is formed by base well 5, which also forms the base region of transistor 23 and the collector region of transistor 24; the P-short region S and the channel region of turn-off transistor 21 are formed respectively by P-short regions 7 and by the outer portions 6b of N well 6; the emitter and collector of transistor 23 are formed respectively by emitter region 6a (including portion 6c) and by epitaxial layer 4, which also forms the base region of transistor 24; and the emitter region of transistor 24 is formed by substrate 2. Turn-on transistor 20 is formed on the periphery of base well 5. More specifically, outer portion 6b of N type region 6 of cells 10 close to the periphery of base well 5 forms the P-short regions S of transistor 20; the portion of base well 5 adjacent to the former (beneath gate regions 16) forms the channel; and epitaxial layer 4 forms the drain region D.

Device 1 is manufactured as follows. On a wafer 100 of semiconductor material comprising substrate 2 and epitaxial layer 4, an initial oxide layer of roughly 5000 Å is grown; this is followed by masking, implantation and oxidizing diffusion of P type doping species (boron) to form base well 5, the edge rings (not shown), and a field oxide layer (not shown) over the whole of surface 13 of wafer 100; masking, implantation and diffusion of N type doping species (preferably phosphorus) to form an array of N wells constituting the emitter regions (6a in Figure 1); masking and removal of the field oxide layer, with the exception of the edge portions; deposition of a gate oxide layer (roughly 600 Å) and a polysilicon layer (roughly 5500 Å); masking and chemical etching to form gate regions 11, 16; implantation of N type doping species (e.g. phosphorus) to form N⁻ type outer portions 6b self-aligned with gate regions 11, 16; and oxidizing diffusion to diffuse the N type doping species and surface oxidize the silicon.

This gives the intermediate structure illustrated in Figure 3, which shows a single cell 10, the base region 5, the emitter region 6a, gate regions 11, outer portions 6b, a gate oxide layer 27 beneath gate regions 11, a polysilicon oxide layer 28 over the gate regions, and a composite layer 29 over emitter region 6a and comprising gate oxide layer 27 and polysilicon oxide layer 28.

This is followed by masking and implantation of P type doping species to form later P-short regions 7, as illustrated in Figure 4, which shows part of the source mask 30 and the implanted P-short regions 31; source mask 30 is removed; and the P-short regions are diffused (brief, lightly oxidizing diffusion) to give the structure illustrated in Figure 5, which shows the P-short regions 7 after diffusion and a source oxide layer 33 formed over the free surface of wafer 100 and over gate regions 11, 16.

Then, further standard steps are carried out, comprising vapour-phase deposition of a vapox oxide layer (to form oxide layer 14 in Figure 1); reflowing; gettering; reoxidation; photolithography of the contacts; deposition and photolithography of the metal regions; passivation, etc. to give the final structure in Figure 1.

Unlike traditional power MOS transistors, most of the current of MCT 1 and IGBTs flows to the center of cells 10 into region 6c, so that, to make the most of the intrinsic conduction characteristic of the device, as conductive a contact as possible must be formed between metal region 18 and region 6c.

As is known, the contact resistance between a metal and silicon (region 6c) depends highly on the doping level of the silicon, especially in the case of N type doping agents. As regards the Figure 1 structure, however, the fact that P-short regions 7 are formed in emitter region 6a means there is clearly a limit to the increase in the surface concentration of region 6a, and the doping level of regions 7 is obviously also limited.

The problem therefore arises of reducing the contact resistance between regions 6c and the respective metal region 18 without impairing the electric characteristics of the device, and using a non-critical fabrication method involving substantially no additional cost.

It is an object of the present invention to provide a simple, non-critical, easily implemented fabrication method for reducing the contact resistance between the emitter and metal regions.

It is a further object of the present invention to provide a device of the aforementioned type, in which the contact resistance is reduced without impairing its electric characteristics.

According to the present invention, there are provided a method of fabricating a power MOS switching device, as claimed in Claim 1, and a power MOS switching device as claimed in Claim 9.

In practice, according to one aspect of the invention, the power device presents an enriched region between the P-short regions; and the enriched region is formed by depositing a nitride layer on the surface of the wafer prior to the source masking step, and using the source mask to define a nitride mask which is used later, after removing the source mask and implanting the P-short regions, to grow a masking oxide layer on the P-short regions but not in the region between them; this masking oxide layer therefore provides for implanting enriching doping species solely in the emitter region portion between the P-short regions.

A preferred, non-limiting embodiment of the present invention will be described by way of example with reference to the accompanying drawings, in which:
Figure 1 shows a cross section of a wafer of semiconductor material integrating a known MCT switch;
Figure 2 shows an electric diagram of the Figure 1 structure;
Figures 3 to 5 show cross sections relative to different steps in the fabrication of the known device in Figure 1;
Figure 6 shows a cross section of a portion of a wafer of semiconductor material integrating an MCT switch in accordance with the present invention;
Figures 7 to 9 show cross sections relative to different steps in the fabrication of the Figure 6 device.

Figure 6 shows the final structure of one embodiment of the device according to the present invention, and which differs from the known structure in Figure 1 by presenting an additional enriched layer 35 between the P-short regions at portion 6c. As such, the regions of the Figure 6 device common to the Figure 1 structure are indicated using the same numbering system with no further description.

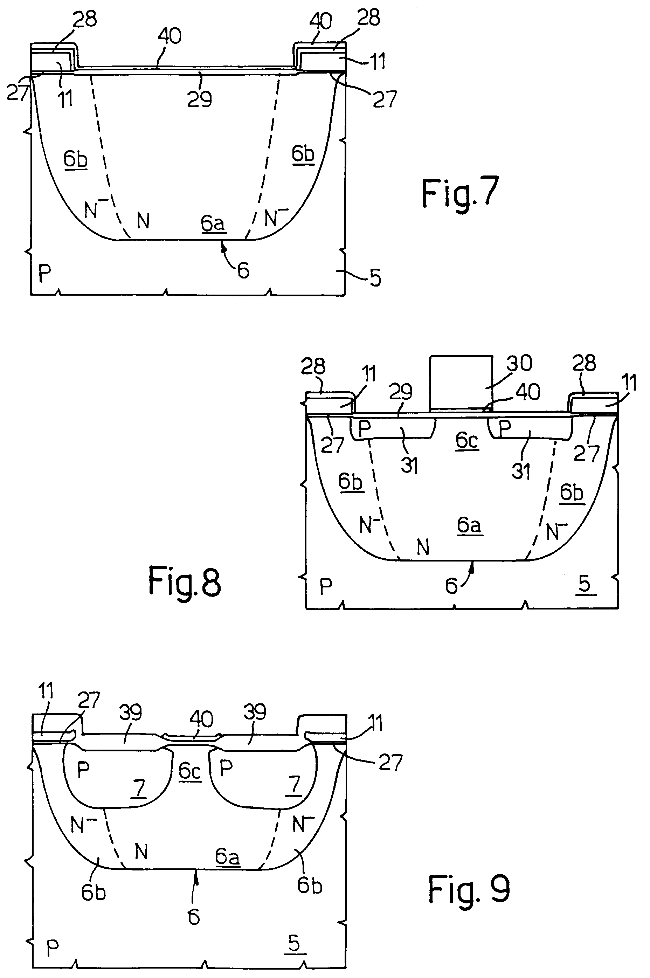

The method of fabricating the Figure 6 device is the same as for the Figure 1 device up to the intermediate structure in Figure 3, at which point, a preferably 700 Å thick nitride layer 40 is deposited over the entire free surface to give the structure in Figure 7.

As in the known method, the same source mask 30 as in Figure 4 is formed to cover the central portion of emitter region 6a; the exposed portion of nitride layer 40 is etched to uncover, among other portions, the oxide layer 29 over N well 6 and to the side of mask 30; and a source implant is made to form regions 31 (Figure 8).

Then, mask 30 is removed and the P-short regions are diffused in an oxidizing way. This high-temperature thermal step provides for diffusing the boron atoms and simultaneously forming regions 7 and a 5000 Å thick oxide layer 39 over P-short regions 7 (and gate regions 11, 16) as shown in Figure 9. The above thickness is expressly chosen to shield the next implantation step.

At this point, nitride layer 40 is removed, and enriching N type doping species (phosphorus, arsenic or antimony) are implanted, which implant is masked entirely by oxide layer 39 with the exception of the portion formerly masked by the nitride layer and in which enriched region 35 in Figure 6 is formed.

The fabrication method then proceeds as for the known device, with vapour-phase deposition of the oxide layer, formation of the contacts and metal regions, and the final steps, to give to the structure in Figure 6.

The advantages of the fabrication method and device according to the present invention are as follows. Firstly, it provides for a structure with a high concentration of doping atoms solely in the region contacting metal region 18, thus reducing contact resistance (and so ensuring optimum conduction of the switching device) with no problem as regards formation of the P-short regions, and without affecting the threshold voltage of turn-off transistors 20 (which depends on the doping level of outer portions 6b of cells 10 forming the channel of transistors 20).

Secondly, as compared with the known method, the fabrication method according to the invention requires no additional masking step, which, besides a far from negligible increase in cost, would be critical as regards alignment with source mask 30.

Clearly, changes may be made to the method and device as described and illustrated herein without, however, departing from the scope of the present invention. In particular, the materials and thicknesses mentioned are purely indicative; the type of doping species used for the layers is in no way binding; and the invention may be applied equally as well to MCTs with a complementary structure.

## Claims

1. A method of fabricating a power MOS switching device, comprising the steps of:
- forming, in a wafer (100) of semiconductor material, a number of cells (10) of a first doping type and a first doping level;
- forming source regions (7) of a second doping type in said cells; the source regions in the same cell being spaced and laterally defining at least one respective inner surface portion (6c) of the respective cell;
characterized in that it comprises the step of:
- forming, in said inner surface portions, contact regions (35) of said first doping type and a second doping level greater than the first.

2. A method as claimed in Claim 1, characterized in that it comprises the steps of:
- selectively forming first regions (40) of oxidation-resistant material (40) on said wafer (100) of semiconductor material;
- selectively forming second regions (39) of insulating material on said wafer of semiconductor material and to the side of said first regions;
- removing said first regions (40); and
- forming said contact regions (35) in said wafer of semiconductor material and to the side of said second regions (39).

3. A method as claimed in Claim 2, characterized in that said step of selectively forming first regions (40) comprises the steps of:
- depositing a layer of said oxidation-resistant material (40) prior to forming said source regions (7);
- forming a source mask (30) of photosensitive material; and
- selectively removing portions of said layer of oxidation-resistant material (40) using said source mask.

4. A method as claimed in Claim 3, characterized in that it comprises the step of implanting source doping species using said source mask (30).

5. A method as claimed in Claim 4, characterized in that said step of implanting source doping species is performed after said step of selectively removing portions of said layer of oxidation-resistant material (40).

6. A method as claimed in one of the foregoing Claims from 3 to 5, characterized in that said step of selectively forming second regions (39) comprises the steps of:
- removing said source mask (30) after said step of selectively removing portions of said layer of oxidation-resistant material (40); and
- thermally oxidizing said wafer (100) of semiconductor material to the side of said first regions (40).

7. A method as claimed in one of the foregoing Claims from 2 to 6, characterized in that said step of forming said contact regions (35) comprises the step of introducing doping species of said first doping type into said inner surface portion (6c).

8. A method as claimed in any one of the foregoing Claims from 1 to 7, characterized in that said oxidation-resistant material is nitride.

9. A power MOS switching device (1) comprising, in a wafer (100) of semiconductor material, a number of cells (10) of a first doping type and a first doping level; each said cell housing spaced source regions (7) of a second doping type; and said source regions laterally defining at least one respective inner surface portion (6c) of the respective cell; characterized in that it comprises contact regions (35) of said first doping type and a second doping level greater than the first, and located at said inner surface portions (6c).

10. A device as claimed in Claim 9, characterized in that it is a MOS controlled thyristor.
